# EUROPÄISCHE PATENTANMELDUNG

(11) **EP 1 262 511 A2**
(43) Veröffentlichungstag der Anmeldung: **04.12.2002**
(21) Anmeldenummer: 02011579.6
(22) Anmeldetag: 27.05.2002
(51) Int. Cl.: C08J 5/18, B32B 27/08

(54) **Gedeckt eingefärbte, hydrolysbeständige, biaxial orientierte Folie aus einem kristallisierbaren Thermoplasten und Verfahren zu ihrer Herstellung**

(30) Priorität: 30.05.2001 DE 10126149
(71) Anmelder: Mitsubishi Polyester Film GmbH, 65023 Wiesbaden (DE)
(72) Erfinder: Murschall, Ursula, Dr., 55283 Nierstein (DE); Kern, Ulrich, Dr., 55218 Ingelheim (DE); Kiehne, Thorsten, Dr., 65185 Wiesbaden (DE)
(74) Vertreter: Plate, Jürgen, Dr.

(57) **Zusammenfassung**

Offenbart ist eine ein- oder mehrschichtige, gedeckt eingefärbte, biaxial orientierte Folie,die mindestens einen kristallisierbaren Thermoplasten als Hauptbestandteil, mindestens ein Pigment und mindestens ein monomeres oder polymeres Carbodiimid als Hydrolysestabilisator enthält. Als weitere Hydrolysestabilisatoren kann sie daneben eine phenolische Verbindung, diese gegebenenfalls kombiniert mit einem organischen Phosphit, oder ein Oxazolin enthalten. Der Hydrolysestabilisator wird allgemein in Form eines Masterbatches zugegeben. Die Folie kann siegelfähig, ein- oder beidseitig beschichtet, chemisch vorbehandelt, coronaund/oder flammbehandelt sein. Die Folie zeigt einen geringen Schrumpf in Längsund Querrichtung. Bei Einwirkung von Feuchtigkeit und Wärme versprödet sie praktisch nicht und behält ihre Reißfestigkeit.

## Beschreibung

Die Erfindung betrifft eine ein- oder mehrschichtige, gedeckt eingefärbte, biaxial orientierte Folie, die als Hauptbestandteil mindestens einen kristallisierbaren Thermoplasten enthält. Sie betrifft ferner ein Verfahren zur Herstellung der Folie und ihre Verwendung.

Gedeckt eingefärbte, biaxial orientierte Folien aus kristallisierbaren Thermoplasten, insbesondere aus kristallisierbaren Polyestern, sind bekannt. Darüber hinaus ist in der nicht vorveröffentlichten DE-A 100 12 140 eine schwer entflammbare, UV-stabilisierte, gedeckt eingefärbte Folie aus einem kristallisierbaren Thermoplasten offenbart. Einige der darin verwendbaren organischen Flammschutzmittel sind jedoch feuchtigkeitsempfindlich, so daß sie mit einem Hydrolysestabilisator kombiniert sind. Als Hydrolysestabilisator offenbart sind phenolische Verbindungen, Alkali- oder Erdalkalistearat sowie Alkali- oder Erdalkalicarbonat. Eine gedeckt eingefärbte, teilkristalline Folie aus einem bibenzolmodifizierten Thermoplasten, insbesondere aus einem bibenzolmodifizierten Polyethylenterephthalat, ist in der nicht vorveröffentlichten DE-A 100 43 776 offenbart. Sie kann eine Kombination aus einem Flammschutzmittel (vorzugsweise einer organischen Phosphorverbindung) und einem phenolischen Hydrolysestabilisator enthalten.

Bekannt und in zahlreichen Varianten beschrieben sind auch funktionalisierte, biaxial orientierte Folien, die kristallisierbare Thermoplasten enthalten. Die Funktionalisierung kann beispielsweise darin bestehen, daß die Folie siegelfähig, beschichtet oder chemisch oder physikalisch (beispielsweise durch Coronaentladung) vorbehandelt ist.

Beispielsweise läßt sich die Oberfläche der Folie durch geeignete Behandlung oder Beschichtung so modifizieren, daß sie siegelfähig, beschreib- oder bedruckbar, metallisierbar, sterilisierbar oder antistatisch wird, eine verbesserte Aromabarriere oder eine verbesserte Haftung an Materialien zeigt, die ansonsten nicht auf der Folienoberfläche haften würden (z.B. fotografische Emulsionen). Durch das Einarbeiten von Additiven in die Folie lassen sich auch Eigenschaften, wie UV-Stabilität oder Flammfestigkeit, einstellen.

So umfaßt die mehrschichtige, biaxial orientierte und thermofixierte Polyesterfolie gemäß der GB-A 1 465 973 eine Schicht aus transparentem Polyethylenterephthalat (PET) und eine Schicht aus ebenfalls transparentem Copolyester. Der Oberfläche der Copolyesterschicht kann mit Hilfe von Walzen eine rauhe Struktur aufgeprägt werden, so daß die Folie beschreibbar wird.

In der EP-A 035 835 ist eine biaxial verstreckte und thermofixierte, mehrschichtige Polyesterfolie beschrieben, die eine Schicht aus einem hochkristallinen Polyester und damit verbunden eine siegelfähige Schicht aus einem im wesentlichen amorphen, linearen Polyester umfaßt. Die letztgenannte Schicht enthält feinverteilt Partikel, wobei der mittlere Durchmesser der Partikel größer ist als die Schichtdicke. Durch diese Partikel werden Oberflächenvorsprünge gebildet, die das unerwünschte Blocken und Kleben an Walzen oder Führungen verhindern. Die Folie läßt sich dadurch besser aufwickeln und verarbeiten. Durch die Wahl von Partikeln mit größerem Durchmesser als die Siegelschicht und den in den Beispielen angegebenen Konzentrationen wird das Siegelverhalten der Folie verschlechtert. Die Siegelnahtfestigkeit der gesiegelten Folie bei 140 °C liegt in einem Bereich von 63 bis 120 N/m (0,97 N/15 mm bis 1,8 N/15 mm Folienbreite).

In der EP-A 432 886 ist eine coextrudierte Folie mit einer Polyester-Basisschicht, einer Deckschicht aus einem siegelfähigen Polyester und einer rückseitigen Polyacrylatbeschichtung beschrieben. Die siegelfähige Deckschicht kann aus einem Copolyester mit Einheiten aus Isophthalsäure und Terephthalsäure bestehen. Durch die rückseitige Beschichtung erhält die Folie ein verbessertes Verarbeitungsverhalten. Die Siegelnahtfestigkeit wird bei 140 °C gemessen. Für eine 11 µm dicke Siegelschicht wird eine Siegelnahtfestigkeit von 761,5 N/m (11,4 N/15 mm) angegeben. Nachteilig an der rückseitigen Acrylatbeschichtung ist, daß diese Seite gegen die siegelfähige Deckschicht nicht mehr siegelt. Die Folie ist damit nur sehr eingeschränkt zu verwenden.

Eine coextrudierte, mehrschichtige, siegelfähige Polyesterfolie ist ferner in der EP-A 515 096 beschrieben. Die Basisschicht der Folie kann Pigmentpartikel, insbesondere solche aus Aluminiumoxid, Titandioxid, Alkalimetallcarbonat, Calciumsulfat oder Bariumsulfat, enthalten. Das führt zu einer weißen Folie. Die siegelfähige Schicht enthält zusätzlich Pigmentierungspartikel, bevorzugt Kieselgelpartikel. Die Partikel können auch auf die bereits extrudierte Folie aufgebracht werden, beispielsweise durch Beschichten mit einer wäßrigen Kieselgel-Dispersion. Hierdurch soll die Folie die guten Siegeleigenschaften beibehalten und gut zu verarbeiten sein. Die Rückseite enthält nur sehr wenige Partikel, die hauptsächlich über das Regranulat in diese Schicht gelangen. Die Siegelnahtfestigkeit wird bei 140 °C gemessen und beträgt mehr als 200 N/m (3 N/15 mm). Für eine 3 µm dicke Siegelschicht wird eine Siegelnahtfestigkeit von 275 N/m (4,125 N/15 mm) angegeben.

Die aus der WO 98/06575 bekannte coextrudierte, mehrschichtige Polyesterfolie umfaßt eine siegelfähige Deckschicht und eine nicht siegelfähige Basisschicht. Die Basisschicht kann dabei aus einer oder mehreren Schichten aufgebaut sein, wobei die innere Schicht mit der siegelfähigen Schicht in Kontakt ist. Die andere (äußere) Schicht bildet dann die zweite, nicht siegelfähige Deckschicht. Die siegelfähige Deckschicht kann auch hieraus Copolyestern mit Einheiten aus Isophthalsäure und Terephthalsäure bestehen. Die Deckschicht enthält jedoch keine Antiblockpartikel. Die Folie enthält außerdem noch mindestens einen UV-Absorber, der in der Basisschicht in einem Anteil von 0,1 bis 10,0 Gew.-% enthalten ist. Als UV-Absorber werden dabei Zinkoxid- oder Titandioxid-Partikel mit einem mittleren Durchmesser von weniger als 200 nm, vorzugsweise jedoch Triazine (z.B. ®Tinuvin 1577 der Fa. Ciba), verwendet. Die Basisschicht ist mit üblichen Antiblockmitteln ausgestattet. Die Folie zeichnet sich durch eine gute Siegelfähigkeit aus, hat jedoch nicht das gewünschte Verarbeitungsverhalten und weist zudem Defizite in den optischen Eigenschaften auf.

Schichten aus Copolyester lassen sich auch durch Auftragen einer entsprechenden wäßrigen Dispersion erzeugen. So ist in der EP-A 144 878 eine Polyesterfolie beschrieben, die auf wenigstens einer Seite eine durchgehende Beschichtung aus dem Copolyester trägt. Die Dispersion wird auf die Folie vor dem Verstrecken bzw. vor dem letzten Verstreckschritt aufgebracht. Die Polyesterbeschichtung besteht aus einem Kondensationsprodukt von verschiedenen Monomeren, die zur Bildung von Polyestern befähigt sind, wie Isophthalsäure, aliphatische Dicarbonsäuren, Sulfomonomere und aliphatische oder cycloaliphatische Glykole.

In der DE-A 23 46 787 sind unter anderem schwer entflammbare Folien aus linearen Polyestern, die mit Carboxyphosphinsäuren modifiziert sind, offenbart. Die Herstellung dieser Folien ist jedoch mit einer Reihe von Problemen verbunden. So ist der Rohstoff sehr hydrolyseempfindlich und muß sehr gut vorgetrocknet werden. Beim Trocknen des Rohstoffes mit Trocknern, die dem Stand der Technik entsprechen, verklebt er, so daß nur unter schwierigsten Bedingungen eine Folie herstellbar ist. Die unter extremen, unwirtschaftlichen Bedingungen hergestellten Folien verspröden zudem bei Temperaturbelastung. Die mechanischen Eigenschaften gehen dabei so stark zurück, daß die Folie unbrauchbar wird. Bereits nach 48 h Temperaturbelastung tritt diese Versprödung auf.

All diese bekannten Folien sind jedoch nicht ausreichend hydrolysebeständig. Des weiteren sind sie nicht in ihren Schrumpfeigenschaften optimiert, so daß sie für viele Anwendungen nicht in Frage kommen.

Es bestand daher die Aufgabe, eine gedeckt eingefärbte, biaxial orientierte Folie bereitzustellen, die gute mechanische und optische Eigenschaften aufweist, einen niedrigen Schrumpf hat, keine Versprödung nach Temperaturbelastung zeigt, wirtschaftlich herstellbar und darüber hinaus möglichst beständig gegen Wasser oder Feuchtigkeit ist und auch mit zusätzlichen Funktionalitäten ausgerüstet werden kann.

Gelöst wurde diese Aufgabe mit Hilfe mindestens eines monomeren, oligomeren oder polymeren Carbodiimids lösen läßt, das als Hydrolysestabilisator in die Folie eingearbeitet ist. Einbußen bei den optischen und mechanischen Eigenschaften der Folie treten überraschenderweise nicht auf.

Gegenstand dervorliegenden Erfindung ist demnach eine ein- oder mehrschichtige, gedeckt eingefärbte, biaxial orientierte Folie, die mindestens einen kristallisierbaren Thermoplasten als Hauptbestandteil und mindestens ein Pigment enthält und dadurch gekennzeichnet ist, daß sie mindestens ein monomeres, oligomeres oder polymeres Carbodiimid enthält.

Die monomeren, oligomeren oder polymeren Carbodiimide sind in der Lage, durch Hydrolyse gebrochene Esterbindungen wiederherzustellen. Bevorzugte Carbodiimide sind lineare aliphatische Carbodiimide, wie Dicyclohexylcarbodiimid und aromatische polymere Carbodiimide, wobei von den letztgenannten solche mit einem Molekulargewicht von 2.000 bis 50.000 und einem Schmelzbereich von 50 bis 300 °C, bevorzugt 60 bis 200 °C (erhältlich beispielsweise unter der Bezeichnung ®Stabaxol P von Rhein Chemie GmbH, Mannheim) besonders bevorzugt sind. Der Anteil dieser Verbindungen beträgt allgemein 0,1 bis 5,0 Gew.-%, bevorzugt 0,2 bis 3,0 Gew.-%, jeweils bezogen auf das Gewicht der einschichtigen Folie bzw. der damit ausgerüsteten Schicht der mehrschichtigen Folie.

Die monomeren, oligomeren oder polymeren Carbodiimide können gegebenenfalls kombiniert sein mit anderen Hydrolysestabilisatoren. Das sind beispielsweise phenolische Verbindungen oder Oxazoline. Geeignete phenolische Verbindungen sind insbesondere sterisch gehinderte Phenole, Thio-bisphenole, Alkylidenbisphenole, Alkylphenole, Hydroxybenzylverbindungen, Acyl-amino-phenole oder Hydroxyphenylpropionate (insbesondere (3,5-Di*-tert*.-butyl-4-hydroxy-phenyl)-propionsäureesterdes Pentaerythrits oder des 1-Octadecanols, erhältlich unter der Bezeichnung ®Irganox von Ciba Specialty Chemicals). Diese Verbindungen sind beispielsweise beschrieben in der Monographie "Kunststoffadditive" von Gächter/Müller, 2. Aufl., Carl Hanser Verlag. Der Anteil der phenolischen Stabilisatoren beträgt allgemein 0,1 bis 8,0 Gew.-%, bevorzugt 0,2 bis 5,0 Gew.-%, jeweils bezogen auf das Gewicht der Folie bzw. der damit ausgerüsteten Schicht (im Fall der mehrschichtigen Folie).

Phenolische Stabilisatoren werden vorzugsweise kombiniert mit organischen Phosphiten, insbesondere mit Triarylphosphiten (erhältlich beispielsweise unter der Bezeichnung ®Irgafos 168 von Ciba Specialty Chemicals). Diese sind in der Lage, Peroxide abzubauen und wirken damit als Sekundärstabilisatoren. Das Gewichtsverhältnis von phenolischen Stabilisatoren zu organischen Phosphiten beträgt dabei allgemein 10 : 90 bis 90 : 10. Solche Mischungen von primären und sekundären Hydrolysestabilisatoren sind ebenfalls kommerziell erhältlich, beispielsweise unter den Bezeichnungen ®Irganox B 561 oder ®Irganox B 225.

Eine bevorzugte erfindungsgemäße Folie enthält sowohl Verbindungen, die die Hydrolysegeschwindigkeit herabsetzen (wie phenolische Verbindungen), als auch Verbindungen, die Esterbindungen wieder herstellen können. Sie ist besonders resistent gegen Feuchtigkeit oder Wasser. In einer bevorzugten Ausführungsform enthält die Folie demgemäß 0,1 bis 5 Gew.-% an polymeren aromatischen Carbodiimiden und 0,1 bis 5 Gew.-% eines Blends aus 30 bis 90 Gew.-% eines organischen Phosphits (insbesondere eines Triarylphosphits) und 70 bis 10 Gew.-% eines Hydroxyphenylpropionats. Der Anteil aller Hydrolysestabilisatoren zusammen beträgt allgemein 0,2 bis 13,0 Gew.-%, bevorzugt 0,4 bis 8,0 Gew.-%, jeweils bezogen auf das Gewicht der Folie bzw. der betreffenden Schicht der mehrschichtigen Folie.

Anders als UV-Stabilisatoren zeigen die Hydrolysestabilisatoren bei einer Wellenlänge von 380 bis 400 nm praktisch keine oder nur eine vergleichsweise geringe Absorption.

Die einschichtige Folie oder mindestens eine Schicht der mehrschichtigen Folie ist mit mindestens einem Pigment gedeckt eingefärbt. Das Pigment ist bevorzugt ein anorganisches Weißpigment, ein anorganisches oder organisches Buntpigment, ein anorganisches Schwarzpigment oder eine Mischung davon. Bei der mehrschichtigen Folien befindet sich das Pigment vorzugsweise in der Basisschicht, kann sich aber statt dessen oder zusätzlich auch in der bzw. den Deckschicht/en und/oder eventuell vorhandenen Zwischenschichten befinden.

Das Pigment wird bevorzugt in Form eines Masterbatches zudosiert, kann aber auch direkt beim Rohstoffhersteller eingearbeitet werden.

Bevorzugte Weißpigmente sind Titandioxid, Bariumsulfat, Calciumcarbonat, Kaolin, Siliciumdioxid, wobei Titandioxid (Anatas- oder Rutil-Typ) und Bariumsulfat besonders bevorzugt sind. Das Titandioxid verursacht innerhalb der Polymermatrix keine Vakuolen während der Folienherstellung. Die Titandioxid-Pigmentpartikel können beschichtet sein, insbesondere mit einen Überzug aus anorganischen Oxiden. Solche beschichteten Partikel sind bekannt und werden beispielsweise in Papieren oder Anstrichmitteln zur Verbesserung der Lichtechtheit eingesetzt. TiO₂ ist photoaktiv. Bei Einwirkung von UV-Strahlen bilden sich freie Radikale auf der Oberfläche der Partikel. Die freien Radikale wiederum können Abbaureaktionen bei den filmbildenden Polymeren auslösen, was sich insbesondere in einer Vergilbung der Folie äußert. In einer bevorzugten Ausführungsform sind die TiO₂-Partikel mit Oxiden des Aluminiums, Siliciums, Zinks oder Magnesiums oder Mischungen verschiedener Oxide beschichtet. TiO₂-Partikel mit einem Überzug aus mehreren dieser Verbindungen sind beispielsweise in der EP-A-044 515 und EP-A-078 633 offenbart. Weiterhin kann der Überzug organische Verbindungen mit polaren und unpolaren Gruppen enthalten. Die organischen Verbindungen müssen bei der Herstellung der Folie durch Extrusion der Polymerschmelze ausreichend thermostabil sein. Polare Gruppen sind beispielsweise -OH; -OR; -COOX; (X = R; H oder Na, R = Alkyl mit 1 - 34 C-Atomen). Bevorzugte organische Verbindungen sind Alkanole und Fettsäuren mit 8 - 30 C-Atomen, insbesondere Fettsäuren und primäre n-Alkanole mit 12 - 24 C-Atomen, sowie Polydiorganosiloxane und/oder Polyorganohydrogensiloxane, wie Polydimethylsiloxan und Polymethylhydrogensiloxan. Die Titandioxid-Pigmentpartikel sind allgemein mit 1 bis 12 g, bevorzugt mit 2 bis 6 g, an anorganischen Oxiden und 0,5 bis 3 g, bevorzugt 0,7 bis 1,5 g, an organischen Verbindungen, bezogen auf 100 g Titandioxidteilchen, beschichtet. Besonders zweckmäßig wird der Überzug mit Hilfe einer wäßrigen Suspension aufgebracht. Die anorganischen Oxide können dabei aus wasserlöslichen Verbindungen - z. B. Alkali-, insbesondere Natriumnitrat, Natriumsilikat (Wasserglas) oder Kieselsäure - in der wäßrigen Suspension ausgefällt werden.

Unter anorganischen Oxiden wie Al₂O₃ oder SiO₂ sind auch die Hydroxide sowie die verschiedenen Entwässerungsstufen der Oxide, wie Oxidhydrate, zu verstehen, wobei die genaue Zusammensetzung und Struktur häufig unbekannt ist. Auf das TiO₂-Pigment werden nach dem Glühen und Mahlen in wäßriger Suspension die Oxidhydrate z. B. des Aluminiums und/oder Siliciums gefällt, die Pigmente dann gewaschen und getrocknet. Diese Ausfällung kann somit direkt in einer Suspension geschehen, wie sie im Herstellungsprozeß nach der Glühung und der sich anschließenden Naßmahlung anfällt. Die Ausfällung der Oxide und/oder Oxidhydrate der jeweiligen Metalle erfolgt aus den wasserlöslichen Metallsalzen im bekannten pH-Bereich, fürdas Aluminium wird beispielsweise Aluminiumsulfat in wäßriger Lösung (pH kleiner als 4) eingesetzt und durch Zugabe von wäßrigerAmmoniaklösung oder Natronlauge im pH-Bereich zwischen 5 und 9, vorzugsweise zwischen 7 und 8,5, das Oxidhydrat gefällt. Geht man von einer Wasserglas- oder Alkalialuminatlösung aus, sollte der pH-Wert der vorgelegten TiO₂-Suspension im stark alkalischen Bereich (pH größer als 8) liegen. Die Ausfällung erfolgt dann durch Zugabe von Mineralsäure, wie Schwefelsäure, im pH-Bereich von 5 bis 8. Nach der Ausfällung der Metalloxide wird die Suspension noch 15 min bis etwa 2 Stunden gerührt, wobei die ausgefällten Schichten eine Alterung erfahren. Das beschichtete Pigment wird dann von derwäßrigen Dispersion abgetrennt und nach dem Waschen bei erhöhter Temperatur, vorzugsweise bei etwa 70 bis 100 °C, getrocknet.

In einer weiteren bevorzugten Ausführungsform ist das Pigment Bariumsulfat, wobei der Anteil des Bariumsulfats allgemein 0,2 bis 40 Gew.-%, bevorzugt 0,3 bis 25 Gew.-%, besonders bevorzugt 1 bis 25 Gew.-%, beträgt, jeweils bezogen auf das Gewicht des kristallisierbaren Thermoplasten. Wie die anderen Pigmente wird auch das Bariumsulfat vorzugsweise in Form eines Masterbatches direkt bei der Folienherstellung zudosiert.

In einer bevorzugten Ausführungsform werden gefällte Bariumsulfat-Typen eingesetzt. Gefälltes Bariumsulfat erhält man aus Bariumsalzen und Sulfaten oder Schwefelsäure als feinteiliges, farbloses Pulver, dessen Korngröße durch die Fällungsbedingungen zu steuern ist. Gefällte Bariumsulfate können nach den üblichen Verfahren, die beispielsweise im *Kunststoff-Journal*, **8** [1974], Nr. 10, S. 30-36 und Nr. 11, S. 26 - 31 beschrieben sind, hergestellt werden. Die mittlere Teilchengröße ist meist relativ klein und liegt vorzugsweise im Bereich von 0,1 bis 5 µm, besonders bevorzugt im Bereich von 0,2 bis 3 µm. Die Dichte des verwendeten Bariumsulfates beträgt üblicherweise etwa 4 bis 5 g/cm³.

Im Falle einer Pigmentierung mit Bariumsulfat enthält die Folie zweckmäßig zusätzlich mindestens einen optischen Aufheller, wobei der optischen Aufheller in einem Anteil von 10 ppm bis 50.000 ppm, insbesondere von 20 ppm bis 30.000 ppm, besonders bevorzugt von 50 ppm bis 25.000 ppm, jeweils bezogen auf das Gewicht des kristallisierbaren Thermoplasten, eingesetzt wird. Vorzugsweise wird auch der optische Aufheller mit Hilfe der Masterbatch-Technologie direkt bei der Folienherstellung zudosiert. Die optischen Aufheller sind in der Lage, UV-Strahlen im Bereich von 360 bis 380 nm zu absorbieren und als längerwelliges, sichtbares blauviolettes Licht wieder abzugeben. Geeignete optische Aufheller sind Benzoxazolderivate, Triazine, Phenylcumarine und Bis-styrylbiphenyle. Solche Aufheller sind beispielsweise erhältlich unter den Bezeichnungen ®Tinopal von Ciba Specialty Chemicals, Basel, Schweiz, ®Hostalux KS von Clariant Deutschland GmbH, oder ®Eastobrite OB-1 von Eastman, USA.

Gegebenenfalls kann die Folie neben dem optischen Aufheller noch einen oder mehrere im Thermoplasten lösliche blaue Farbstoffe enthalten. Als geeignete blaue Farbstoffe haben sich Ultramarinblau und Anthrachinonfarbstoffe, insbesondere Sudanblau 2 der BASF AG, Ludwigshafen, erwiesen. Der Anteil des bzw. der blauen Farbstoffe(s) beträgt allgemein 10 bis 10.000 ppm, bevorzugt 20 bis 5.000 ppm, besonders bevorzugt 50 ppm bis 1.000 ppm, jeweils bezogen auf das Gewicht des mindestens einen kristallisierbaren Thermoplasten.

In einer besonders bevorzugten Ausführungsform enthält die erfindungsgemäße Folie als Hauptbestandteil ein kristallisierbares Polyethylenterephthalat sowie 1 bis 25 Gew.-% gefälltes Bariumsulfat, zweckmäßigerweise mit einem Teilchendurchmesser von 0,4 bis 1 µm, wobei ®Blanc fixe XR-HX oder ®Blanc fixe HXH von der Firma Sachtleben Chemie besonders bevorzugt wird.

In einer weiteren Ausführungsform ist die erfindungsgemäße Folie bunt eingefärbt. Im Fall der mehrschichtigen Folie kann ein anorganisches oder organisches Buntpigment und/oder ein anorganisches Schwarzpigment in der Basis- und/oder in der bzw. in den Deckschicht(en) enthalten sein.

Zu den anorganischen Schwarzpigmenten zählen insbesondere verschiedene Rußpigmente (Flame-, Channel- oder Furnace-Ruße), die auch beschichtet sein können, sowie Kohlenstoffpigmente, die sich von den Rußpigmenten durch einen höheren Aschegehalt unterscheiden, und oxidische Schwarzpigmente, wie Eisenoxidschwarz und Mischungen von Kupfer-, Chrom- und Eisenoxid-Pigmenten (Mischphasenpigmente).

Geeignete anorganische Buntpigmente sind oxidische Buntpigmente, hydroxylhaltige Pigmente, sulfidische Pigmente und Chromate. Beispiele für oxidische Buntpigmente sind Eisenoxidrot, Titanoxid/Nickeloxid/Antimonoxid-Mischphasenpigmente, Titandioxid/Chromoxid-Pigmente, Antimonoxid-Mischphasenpigmente, Mischungen von Eisen-, Zink- und Titanoxiden, Chromoxid, Eisenoxidbraun, Spinelle des Systems Kobalt-/Aluminium-/Titan-/Nickel-/Zinkoxid und Mischphasenpigmente auf Basis von anderen Metalloxiden. Typische hydroxylhaltige Pigmente sind beispielsweise Oxid-Hydroxide des dreiwertigen Eisens, wie FeOOH. Beispiele für sulfidische Pigmente sind Cadmiumsulfid-Selenide, Cadmium-/Zinksulfide sowie Natrium/Aluminium-Silikate mit polysulfidartig gebundenem Schwefel im Gitter. Beispiele für Chromate sind Bleichromate, die in den Kristallformen monoklin, rhombisch und tetragonal vorliegen können.

Die organischen Buntpigmente werden in der Regel eingeteilt in Azopigmente und sogenannte Nicht-Azopigmente. Charakteristisch für die Azopigmente ist die Azo (-N=N-)-Gruppe. Azopigmente können Monoazopigmente, Diazopigmente, Diazokondensationspigmente, Salze von Azofarbsäuren und Mischungen aus den Azopigmenten sein. Die Buntpigmente können wie die Weiß- und Schwarzpigmente unbeschichtet oder mit anorganischen und/oder organischen Substanzen beschichtet vorliegen. Das Schwarz- oder Buntpigment wird bevorzugt in Form eines Masterbatches zudosiert, kann aber auch direkt beim Rohstoffhersteller eingearbeitet werden.

Der Anteil des Pigments oder Pigmentgemischs beträgt allgemein 0,2 bis 40 Gew.-%, bevorzugt 0,3 bis 25 Gew.-%, jeweils bezogen auf das Gewicht des kristallisierbaren Thermoplasten der betreffenden Schicht.

Die erfindungsgemäße Folie enthält als Hauptbestandteil einen kristallisierbaren Thermoplasten, insbesondere einen kristallisierbaren Polyester oder Copolyester. Geeignete kristallisierbare bzw. teilkristalline (Co-)Polyester sind beispielsweise Polyethylenterephthalat (PET), Polyethylennaphthalat (PEN), Polybutylenterephthalat (PBT), bibenzolmodifiziertes (= bibenzoylmodifiziertes) Polyethylenterephthalat (PETBB), bibenzolmodifiziertes Polybutylenterephthalat (PBTBB) und bibenzolmodifiziertes Polyethylennaphthalat (PENBB), wobei Polyethylenterephthalat (PET) und bibenzolmodifiziertes Polyethylenterephthalat (PETBB) bevorzugt sind.

Im Rahmen der vorliegenden Erfindung sollen unter "kristallisierbaren Thermoplasten" kristallisierbare Homopolymere, kristallisierbare Copolymere, kristallisierbare Compounds, kristallisierbares Rezyklat oder andere Varianten von kristallisierbaren Thermoplasten verstanden werden.

Zur Herstellung von kristallisierbaren, thermoplastischen (Co-)Polyestern können neben den Hauptmonomeren, wie Dimethylterephthalat (DMT), Ethylenglykol (EG), Propylenglykol (PG), Butan-1,4-diol, Terephthalsäure (TA), Benzoldicarbonsäure und/ oder Naphthalin-2,6-dicarbonsäure (NDA), auch noch Isophthalsäure (IPA) und/ oder *cis*- und/oder *trans*-1,4-Cyclohexan-dimethanol (c-CHDM, *t*-CHDM oder *c*/*t*-CHDM) verwendet werden.

Die Standardviskosität SV (DCE) des Polyethylenterephthalats liegt allgemein zwischen 600 und 1.000, vorzugsweise zwischen 700 und 900.

Bevorzugte Ausgangsmaterialien zur Herstellung der erfindungsgemäßen Folie sind kristallisierbare Thermoplaste mit einer Kristallitschmelztemperatur Tm von 180 bis 365 °C und mehr, vorzugsweise von 180 bis 310 °C, einem Kristallisationstemperaturbereich Tc zwischen 75 und 280 °C, einer GlasübergangstemperaturTg von 65 bis 130 °C (bestimmt durch Differential Scanning Calorimetry (DSC) bei einer Aufheizgeschwindigkeit von 20 °C/min), mit einer Dichte von 1,10 bis 1,45 (bestimmt gemäß DIN 53479) und einer Kristallinität zwischen 5 und 65 %, vorzugsweise 20 und 65 %.

Das Schüttgewicht (gemessen nach DIN 53466) liegt zwischen 0,75 und 1,0 kg/dm³, bevorzugt zwischen 0,80 und 0,90 kg/dm³.

Die Polydispersität (= Verhältnis M_{w} zu Mₙ) des Thermoplasten, gemessen durch Gelpermeationschromatographie (GPC), liegt vorzugsweise zwischen 1,5 und 4,0, besonders bevorzugt zwischen 2,0 und 3,5. "Hauptbestandteil" heißt, daß der Anteil des mindestens einen teilkristallinen Thermoplasten bevorzugt zwischen 50 und 99 Gew.-%, besonders bevorzugt zwischen 75 und 95 Gew.-%, beträgt, jeweils bezogen auf das Gesamtgewicht der Folie bzw. das Gesamtgewicht der Schicht in der Folie. Die restlichen Anteile können neben dem Hydrolysestabilisator weitere, für biaxial orientierte, gedeckt eingefärbte Folien übliche Additive ausmachen.

Die erfindungsgemäße Folie kann sowohl einschichtig als auch mehrschichtig sein. In der mehrschichtigen Ausführungsform ist die Folie aus mindestes einer Kernschicht, mindestens einer Deckschicht und gegebenenfalls mindestens einer Zwischenschicht aufgebaut, wobei insbesondere ein dreischichtiger A-B-A- oder A- B-C -Aufbau bevorzugt ist. Für diese Ausführungsform ist es wesentlich, daß der kristallisierbare Thermoplast der Kernschicht eine ähnliche Standardviskosität besitzt wie der daran angrenzenden Deckschicht(en). Der Thermoplast ist wiederum bevorzugt ein Polyethylenterephthalat.

In einer besonderen Ausführungsform können die Deckschichten und/oder die Zwischenschichten der mehrschichtigen Folie auch aus einem Polyethylennaphthalat Homopolymeren oder aus Polyethylenterephthalat/Polyethylennaphthalat-Copolymeren oder einem Compound bestehen. In dieser Ausführungsform haben die Thermoplasten der Deckschichten ebenfalls ähnliche Standardviskositäten wie das Polyethylenterephthalat der Kernschicht.

In der mehrschichtigen Ausführungsform sind der oder die Hydrolysestabilisatoren vorzugsweise in der Basisschicht enthalten. Jedoch können nach Bedarf auch die Deckschichten und/oder eventuell vorhandene Zwischenschichten mit Hydrolysestabilisatoren in den für die Monofolie angegebenen Anteilen ausgerüstet sein. Anders als in der einschichtigen Ausführungsform bezieht sich hier der Anteil der Stabilisatoren auf das Gewicht der ausgerüsteten Schicht.

Die erfindungsgemäße Folie zeigt gute mechanische Eigenschaften. Dazu zählen unter anderem ein hoher E-Modul (in Längsrichtung = Maschinenrichtung (MD) größer als 3.200 N/mm², bevorzugt größer als 3.500 N/mm²; in Querrichtung (TD) größer als 3.500 N/mm², bevorzugt größer als 3.800 N/mm²; jeweils bestimmt gemäß ISO 527-1-2) sowie gute Reißfestigkeitswerte (in MD mehr als 100 N/mm²; in TD mehr als 130 N/mm²).

Sie zeigt daneben einen niedrigen Schrumpf. Das bedeutet, daß die Folie in Längswie auch in Querrichtung weniger als 2,0%, bevorzugt weniger als 1,8%, besonders bevorzugt weniger als 1,6% schrumpft, wenn sie 15 min lang auf 150 °C erhitzt wurde (DIN 40 634). Diese Schrumpfwerte können über das Herstellverfahren wie auch durch eine anschließende Off-line-Nachbehandlung erreicht werden. Bei der Off-line-Nachbehandlung wird die Folie weitestgehend ohne Zug durch einen Wärmeofen geführt, wo sie einer Temperatur im Bereich von 160 bis 210°C 1 Sekunde bis 2 Minuten lang ausgesetzt wird. Beim Herstellprozeß kann der Schrumpf durch Einstellung der Thermofixiertemperatur eingestellt werden. Die Thermofixiertemperatur liegt zwischen 180°C und 260°C, insbesondere zwischen 220°C und 250°C.

Die Folie läßt sich zudem bei ihrer Herstellung sowohl in Längs- als auch in Querrichtung hervorragend und ohne Abrisse orientieren. Die orientierte (= verstreckte) Folie hat allgemein eine Dicke von 1 bis 500 µm, bevorzugt von 5 bis 350 µm, besonders bevorzugt von 10 bis 300 µm.

Ferner besitzt die erfindungsgemäße Folie eine gute Hydrolysebeständigkeit. Das bedeutet, daß sie im Klimatest (Feuchte-Langzeittest) nach 1.000 Stunden bei 85 °C und 95% relativer Luftfeuchte im Autoklaven Reißfestigkeiten von mehr als 100 N/mm² in Längs- und Querrichtung aufweist. Sie besteht damit den in der Automobilindustrie üblichen Klimatest. PET-Folien ohne Hydrolysestabilisatoren erfüllen ihn dagegen nicht.

Die Folie versprödet auch nicht bei Temperaturbelastung. Das bedeutet, daß sich die mechanischen Eigenschaften der Folie selbst nach 1.000 Stunden Tempern bei 130 °C in einem Umluftofen nur unwesentlich verschlechtern.

Zu den guten optischen Eigenschaften der Folie zählen beispielsweise eine niedrige Lichttransmission (kleiner als 85 %, bevorzugt kleiner als 82 %), eine niedrige Trübung (weniger als 30%) sowie ein niedriger Gelbwert (YID weniger als 30, bevorzugt weniger als 28). Angesichts der erreichten Hydrolysestabilität sind diese Werte überraschend gut.

Die Folie läßt sich auch wirtschaftlich herstellen. So können die Rohstoffe bzw. die Rohstoffkomponenten, die zur Herstellung der Folie benötigt werden, mit üblichen Industrietrocknern, wie Vakuumtrocknern, Wirbelschichttrocknern, Fließbett- oder Festbetttrocknern (Schachttrocknern), getrocknet werden ohne daß die Rohstoffe verkleben oder thermisch abgebaut werden.

Des weiteren ist die erfindungsgemäße Folie ohne Umweltbelastung rezyklierbar, wobei die aus dem Rezyklat hergestellte Folie praktisch keine Verschlechterung in den optischen Eigenschaften (insbesondere beim Gelbwert) oder den mechanischen Eigenschaften gegenüber einer aus neuen Ausgangsmaterialien hergestellten zeigt.

Basisschicht und/oder Deckschicht(en) können neben dem/den Hydrolysestabilisatoren und den bisher beschriebenen Additiven zusätzlich weitere übliche Additive, wie Stabilisatoren und Antiblockmittel, enthalten. Sie werden zweckmäßig dem Polymer bzw. der Polymermischung bereits vor dem Aufschmelzen zugesetzt.

Als Additive können auch Mischungen von zwei und mehr verschiedenen Antiblockmitteln oder Mischungen von Antiblockmitteln gleicher Zusammensetzung, aber unterschiedlicher Partikelgröße, gewählt werden. Die Partikel können den einzelnen Schichten in den üblichen Anteilen, z.B. als glykolische Dispersion, während der Polykondensation oder über Masterbatche bei der Extrusion zugegeben werden. Als besonders geeignet haben sich Pigmentanteile von 0,0001 bis 10,0 Gew.-%, bezogen auf das Gewicht der Deckschichten, erwiesen.

Die erfindungsgemäße Folie kann zusätzlich funktionalisiert sein, d. h. sie kann beispielsweise siegelfähig, ein- oder beidseitig beschichtet, chemisch vorbehandelt, UV-stabilisiert, corona- und/oder flammbehandelt sein, je nach Erfordernis.

In einer Weiterbildung ist die Folie UV-stabil ausgerüstet. Licht, insbesondere der ultraviolette Anteil der Sonnenstrahlung, d. h. der Wellenlängenbereich von 280 bis 400 nm, induziert bei Thermoplasten Abbauvorgänge. Die Folge davon ist, daß sich nicht nur das visuelle Erscheinungsbild durch eintretende Farbänderung bzw. Vergilbung ändert, sondern daß auch die mechanisch-physikalischen Eigenschaften der Folien aus den Thermoplasten äußerst negativ beeinflußt werden. Die Unterbindung dieser photooxidativen Abbauvorgänge ist von erheblichertechnischer und wirtschaftlicher Bedeutung, da andernfalls die Anwendungsmöglichkeiten von zahlreichen Thermoplasten drastisch eingeschränkt sind. Polyethylenterephthalate beginnen beispielsweise schon unterhalb von 360 nm UV-Licht zu absorbieren; ihre Absorption nimmt unterhalb von 320 nm beachtlich zu und ist unterhalb von 300 nm sehr ausgeprägt. Die maximale Absorption liegt im Bereich zwischen 280 und 300 nm. In Gegenwart von Sauerstoff werden hauptsächlich Kettenspaltungen beobachtet, jedoch keine Vernetzungen. Kohlenmonoxid, Kohlendioxid und Carbonsäuren stellen die mengenmäßig überwiegenden Photooxidationsprodukte dar. Neben der direkten Photolyse der Estergruppen müssen noch Oxidationsreaktionen in Erwägung gezogen werden, die über Peroxidradikale ebenfalls die Bildung von Kohlendioxid zur Folge haben. Die Photooxidation von Polyethylenterephthalaten kann auch über Wasserstoffabspaltung in α-Stellung der Estergruppen zu Hydroperoxiden und deren Zersetzungsprodukten sowie zu damit verbundenen Kettenspaltungen führen (H. Day, D. M. Wiles, *J. Appl. Polym. Sci.* **16** [1972] S. 203).

UV-Stabilisatoren, d.h. UV-Absorber als Lichtschutzmittel, sind chemische Verbindungen, die in die physikalischen und chemischen Prozesse des lichtinduzierten Abbaus eingreifen. Ruß und andere Pigmente können teilweise einen Lichtschutz bewirken. Diese Substanzen sind jedoch für gedeckt eingefärbte Folien ungeeignet, da sie zur Verfärbung oder Farbänderung führen. Geeignete UV-Stabilisatoren als Lichtschutzmittel sind UV-Stabilisatoren, die mindestens 70 %, bevorzugt mindestens 80 %, besonders bevorzugt mindestens 90 %, des UV-Lichts im Wellenlängenbereich von 180 bis 380 nm, vorzugsweise 280 bis 350 nm, absorbieren. Besonders geeignete UV-Stabilisatoren sind zudem im Temperaturbereich von 260 bis 300 °C thermisch stabil, d.h. sie zersetzen sich nicht in Spaltprodukte und gasen nicht aus. Geeignete UV-Stabilisatoren als Lichtschutzmittel sind beispielsweise 2-Hydroxy-benzophenone, 2-Hydroxy-benzotriazole, nickelorganische Verbindungen, Salicylsäureester, Zimtsäureester-Derivate, Resorcin-monobenzoate, Oxalsäureanilide, Hydroxybenzoesäureester, Benzoxazinone, sterisch gehinderte Amine und Triazine, wobei die 2-Hydroxy-benzotriazole, die Benzoxazinone und die Triazine bevorzugt sind. Es war für die Fachwelt völlig überraschend, daß der Einsatz von UV-Stabilisatoren in Kombination mit einer hydrolysebeständigen Ausrüstung zu brauchbaren Folien mit hervorragenden Eigenschaften führt. Der Fachmann hätte vermutlich zunächst versucht, eine gewisse UV-Stabilität über einen Oxidationsstabilisator zu erreichen, hätte jedoch nach Bewitterung festgestellt, daß die Folie schnell gelb wird.

Aus der Literatur sind UV-Stabilisatoren bekannt, die UV-Strahlung absorbieren und somit Schutz bieten. Der Fachmann hätte dann wohl einen dieser bekannten und handelsüblichen UV-Stabilisatoren eingesetzt, dabei jedoch festgestellt, daß der UV-Stabilisator eine mangelnde thermische Stabilität hat und sich bei Temperaturen zwischen 200 und 240 °C zersetzt oder ausgast. Um die Folie nicht zu schädigen, hätte er große Mengen (ca. 10 bis 15 Gew.-%) an UV-Stabilisator einarbeiten müssen, damit dieser das UV-Licht wirklich wirksam absorbiert. Bei diesen hohen Konzentrationen vergilbt jedoch die Folie schon in kurzer Zeit nach der Herstellung. Auch die mechanischen Eigenschaften werden negativ beeinflußt. Beim Verstrecken tauchen ungewöhnliche Probleme auf, wie Abrisse wegen mangelnder Festigkeit, d.h. E-Modul, Düsenablagerungen, was zu Profilschwankungen führt, Ablagerung von UV-Stabilisator auf den Walzen, was zur Beeinträchtigung der optischen Eigenschaften (starke Trübung, Klebedefekt, inhomogene Oberfläche) führt, und Ablagerungen im Streck- und Fixierrahmen, die auf die Folie tropfen.

Es war daher überraschend, daß bereits mit niedrigen Konzentrationen des UV-Stabilisators ein hervorragender UV-Schutz erzielt wird. Besonders überraschend war, daß sich dabei der Gelbwert der Folie im Vergleich zu einer nicht-stabilisierten Folie im Rahmen der Meßgenauigkeit nicht ändert. Die Folie zeichnet sich außerdem durch eine exzellente Optik, ein ausgezeichnetes Profil und eine ausgezeichnete Planlage aus. Die UV-stabilisierte Folie läßt sich hervorragend verstrecken, so daß sie verfahrenssicher und stabil hergestellt werden kann. Damit ist die Folie auch wirtschaftlich rentabel herstellbar. Des weiteren ist es sehr überraschend, daß auch das Regenerat wieder einsetzbar ist, ohne den Gelbwert der Folie negativ zu beeinflussen.

In einer ganz besonders bevorzugten Ausführungsform enthält die erfindungsgemäße Folie als UV-Stabilisator 0,1 bis 5,0 Gew.-% 2-(4,6-Diphenyl-[1,3,5]triazin-2-yl)-5-hexyloxy-phenol der Formel 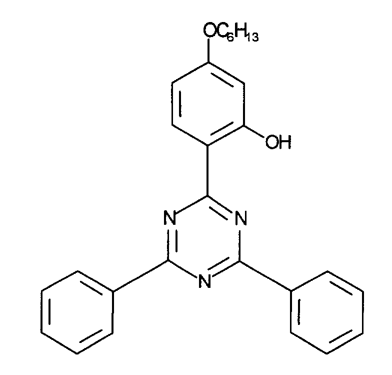 oder 0,1 bis 5,0 Gew.-% 2,2'-Methylen-bis-[6-benzotriazol-2-yl-4-(1,1,2,2-tetramethyl-propyl)-phenol] der Formel 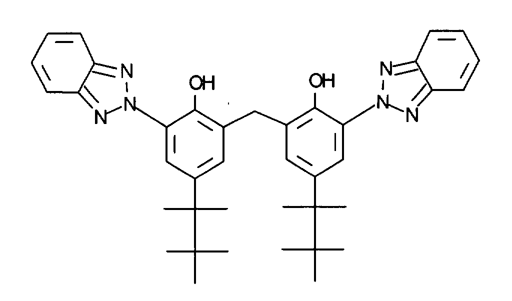 oder 0,1 bis 5,0 Gew.-% 2,2'-(1,4-Phenylen)-bis-([3,1]benzoxazin-4-on)der Formel 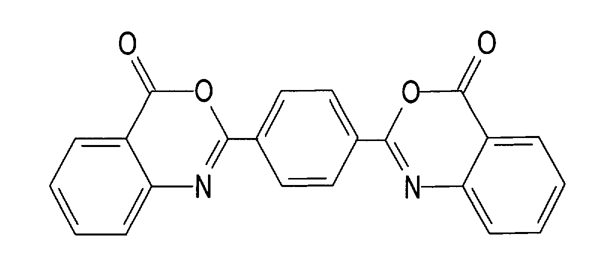 In einer weiteren Ausführungsform können auch Mischungen dieser UV-Stabilisatoren oder Mischungen von mindestens einem dieser UV-Stabilisatoren mit anderen UV-Stabilisatoren eingesetzt werden, wobei die Gesamtkonzentration an Lichtschutzmittel vorzugsweise zwischen 0,1 und 5,0 Gew.-%, besonders bevorzugt im Bereich von 0,5 bis 3,0 Gew.-%, liegt, bezogen auf das Gewicht der ausgerüsteten Schicht.

In einer weiteren Ausführungsform ist die erfindungsgemäße Folie flammhemmend ausgerüstet. Flammhemmend bedeutet, daß die Folie in einer sogenannten Brandschutzprüfung die Bedingungen nach DIN 4102 Teil 2 und insbesondere die Bedingungen nach DIN 4102 Teil 1 erfüllt und in die Baustoffklasse B 2 und insbesondere B1 der schwer entflammbaren Stoffe eingeordnet werden kann. Des weiteren soll die gegebenenfalls flammhemmend ausgerüstete Folie den UL-Test 94 "Horizontal Burning Test for Flammability of Plastic Material" bestehen, so daß sie in die Klasse 94 VTM-0 eingestuft werden kann. Die Folie enthält demgemäß ein Flammschutzmittel, das über die sogenannte Masterbatch-Technologie direkt bei der Folienherstellung zudosiert wird, wobei der Anteil des Flammschutzmittels allgemein 0,5 bis 30,0 Gew.-%, bevorzugt 1,0 bis 20,0 Gew.-%, beträgt, jeweils bezogen auf das Gesamtgewicht der einschichtigen Folie oder der betreffenden Schicht der mehrschichtigen Folie. Im Masterbatch beträgt der Anteil des Flammschutzmittels allgemein 5,0 bis 60,0 Gew.-%, bevorzugt 10,0 bis 50,0 Gew.-%, jeweils bezogen auf das Gesamtgewicht des Masterbatches. Das Flammschutzmittel wird dabei im Trägermaterial dispergiert oder kann auch im Thermoplasten chemisch gebunden sein. Geeignete Flammschutzmittel sind beispielsweise Bromverbindungen, Chlorparaffine und andere Chlorverbindungen, Antimontrioxid und Aluminiumtrihydrate. Die Halogenverbindungen haben allerdings den Nachteil, daß dabei halogenhaltige Nebenprodukte entstehen können. Im Brandfall entstehen insbesondere Halogenwasserstoffe. Nachteilig ist auch die geringe Lichtbeständigkeit einer damit ausgerüsteten Folie. Weitere geeignete Flammschutzmittel sind beispielsweise monomere oder polymere, cyclische oder acyclische, organische Phosphorverbindungen wie Carboxyphosphinsäuren und/oder deren Anhydride sowie Alkanphosphonsäureester, vorzugsweise Methanphosphonsäureester, wie Methanphosphonsäure-bis-(5-ethyl-2-methyl-2-oxo-2λ5-[1,3,2]dioxaphosphinan-5-ylmethylester). Wesentlich ist, daß die organische Phosphorverbindung im Thermoplasten löslich ist, da andernfalls die geforderten optischen Eigenschaften nicht erfüllt werden.

Ganz überraschend haben Brandschutzversuche nach DIN 4102 und dem UL-Test gezeigt, daß es im Falle einer dreischichtigen Folie durchaus ausreichend ist, die 0,5 bis 2 µm dicken Deckschichten mit Flammschutzmitteln auszurüsten, um eine verbesserte Flammhemmung zu erreichen. Bei Bedarf und bei hohen Brandschutzanforderungen kann auch die Kernschicht mit Flammschutzmitteln ausgerüstet sein, d. h. eine sogenannte Grundausrüstung beinhalten.

Auch die mit Flammschutzmitteln ausgerüstete Folie zeigt nach 1.000 Stunden Tempern bei 130 °C im Umluftofen keine Versprödung und keine Verschlechterung der mechanischen Eigenschaften, so daß sie den Klimatest der Automobilindustrie besteht. Nicht hydrolysestabilisierte, flammfeste Folien zeigen nach dem beschriebenen Tempern dagegen eine starke Versprödung.

Ebenso kann die Folie ein- oder beidseitig nach bekannten Verfahren mit einer üblichen funktionalen Beschichtung versehen sein. Zur Herstellung der Beschichtung lassen sich beispielsweise einsetzen: Acrylate gemäß WO 94/13476, Ethylvinylalkohole, PVDC, Wasserglas (Na₂SiO₄), hydrophilische Polyester wie 5-Natriumsulfoisophthalsäurehaltige PET/IPA-Polyester(EP-A 144 878, US-A4 252 885 oder EP-A 296 620), Vinylacetate (WO 94/13481), Polyvinylacetate, Polyurethane, Alkali- oder Erdalkalisalze von (C₁₀-C₁₈)Fettsäuren, Copolymere mit Einheiten aus Butadien und Acrylnitril, (Meth)acrylsäure oder einem (Meth)acrylsäure-alkylester. Außerdem kann die Beschichtung übliche Additive (z.B. Antiblockmittel, pH-Stabilisatoren) in Anteilen von etwa 0,05 bis 5,0 Gew.-%, bevorzugt 0,1 bis 3,0 Gew.-%, jeweils bezogen auf das Gewicht der Beschichtungsflüssigkeit, enthalten.

Die genannten Stoffe oder Zusammensetzungen werden als verdünnte - vorzugsweise wäßrige - Lösung, Emulsion oder Dispersion auf eine oder beide Folienoberflächen aufgetragen. Anschließend wird das Lösungsmittel verflüchtigt. Die Beschichtung wird bevorzugt in-line aufgebracht, d.h. während des Folienherstellprozesses, zweckmäßigerweise vor der Querstreckung. Besonders bevorzugt ist die Aufbringung nach dem "Reverse gravure-roll coating"-Verfahren, mit dem äußerst homogene Schichtdicken erhalten werden. Werden die In-line-Beschichtungen nach der Längsverstreckung aufgebracht, reicht gewöhnlich die Temperaturbehandlung vor der Querverstreckung aus, um das Lösungsmittel zu verflüchtigen und die Beschichtung zu trocknen. Die getrockneten Beschichtungen haben dann Schichtdicken von 5 bis 100 nm, bevorzugt 20 bis 70 nm, insbesondere 30 bis 50 nm.

Für bestimmte Anwendungen kann es auch zweckmäßig sein, eine oder beide Seiten der Folie durch Behandlung mit Säuren chemisch vorzubehandeln. Für diese sogenannte Ätzhaftvermittlung eignen sich insbesondere Trichloressigsäure, Dichloressigsäure oder Flußsäure, die für eine kurze Zeit (zwischen etwa 1 und 120 Sekunden) auf die Oberfläche einwirkt und dann wieder entfernt wird, zweckmäßig mit Hilfe eines sogenannten Luftmessers. Gegebenenfalls wird die Folie anschließend getrocknet. Dadurch erhält die Folie eine sehr reaktive, amorphe Oberfläche.

Wo eine sehr gute Siegelfähigkeit gefordert wird und wo diese Eigenschaft nicht über eine In-line-Beschichtung erreicht werden kann, ist die erfindungsgemäße Folie zumindest dreischichtig aufgebaut und umfaßt dann in einer besonderen Ausführungsform die Basisschicht B, eine siegelfähige Deckschicht A und eine gegebenenfalls siegelfähige Deckschicht C. Ist die Deckschicht C ebenfalls siegelfähig, dann sind die beiden Deckschichten vorzugsweise identisch.

Die durch Coextrusion auf die Basisschicht B aufgebrachte siegelfähige Deckschicht A ist auf Basis von Polyestercopolymeren aufgebaut und besteht im wesentlichen aus Copolyestern, die überwiegend aus Isophthalsäure-, Biphenyldicarbonsäure- und Terephthalsäure-Einheiten und aus Ethylenglykol-Einheiten zusammengesetzt sind. Die restlichen Monomereinheiten stammen aus anderen aliphatischen, cycloaliphatischen oder aromatischen Diolen bzw. Dicarbonsäuren, wie sie auch in der Basisschicht vorkommen können. Die bevorzugten Copolyester, die die gewünschten Siegeleigenschaften bereitstellen, sind solche, die aus Etylenterephthalat- und Ethylenisophthalat-Einheiten und aus Ethylenglykol-Einheiten aufgebaut sind. Der Anteil an Ethylenterephthalat beträgt 40 bis 95 mol-% und der entsprechende Anteil an Ethylenisophthalat 60 bis 5 mol-%. Bevorzugt sind Copolyester, bei denen der Anteil an Ethylenterephthalat 50 bis 90 mol-% und der entsprechende Anteil an Ethylenisophthalat 50 bis 10 mol-% beträgt und ganz bevorzugt sind Copolyester, bei denen der Anteil an Ethylenterephthalat 60 bis 85 mol-% und der entsprechende Anteil an Ethylenisophthalat 40 bis 15 mol-% beträgt.

Für die gegebenenfalls siegelfähige Deckschicht C und für eventuelle Zwischenschichten können prinzipiell die gleichen Polymeren verwendet werden, die auch in der Basisschicht Verwendung finden.

Die gewünschten Siegel- und Verarbeitungseigenschaften der erfindungsgemäßen Folie werden aus der Kombination der Eigenschaften des verwendeten Copolyesters für die siegelfähige Deckschicht und den Topographien der siegelfähigen Deckschicht A und der gegebenenfalls siegelfähigen Deckschicht C erhalten.

Die Siegelanspringtemperatur von 110 °C und die Siegelnahtfestigkeit von mindestens 1,3 N/15mm wird erreicht, wenn für die siegelfähige Deckschicht A die oben näher beschriebenen Copolymere verwendet werden. Die besten Siegeleigenschaften der Folie erhält man, wenn dem Copolymeren keine weiteren Additive, insbesondere keine anorganischen oder organischen Filler zugegeben werden. Für diesen Fall erhält man bei vorgegebenem Copolyester die niedrigste Siegelanspringtemperatur und die höchsten Siegelnahtfestigkeiten. Allerdings ist in diesem Fall das Handling der Folie schlecht, da die Oberfläche der siegelfähigen Deckschicht A stark zum Verblocken neigt. Die Folie läßt sich kaum wickeln und ist für eine Weiterverarbeitung auf schnelllaufenden Verpackungsmaschinen nicht geeignet. Zur Verbesserung des Handlings der Folie und der Verarbeitbarkeit ist es notwendig, die siegelfähige Deckschicht A zu modifizieren. Dies geschieht am besten mit Hilfe von geeigneten Antiblockmitteln einer ausgewählten Größe, die in einer bestimmten Konzentration der Siegelschicht zugegeben werden und zwar derart, daß einerseits das Verblocken minimiert und andererseits die Siegeleigenschaften nur unwesentlich verschlechtert werden.

Zur Einstellung weiterer gewünschter Eigenschaften kann die Folie auch corona- bzw. flammbehandelt sein. Die Behandlungsintensität wird allgemein so gewählt, daß die Oberflächenspannung der Folie nach der Behandlung mehr als 45 mN/m beträgt.

Basisschicht und/oder Deckschicht(en) können neben dem/den Hydrolysestabilisatoren und den bisher beschriebenen Additiven zusätzlich weitere übliche Additive, wie Stabilisatoren und Antiblockmittel, enthalten. Sie werden zweckmäßig dem Polymer bzw. der Polymermischung bereits vor dem Aufschmelzen zugesetzt.

Gegenstand der vorliegenden Erfindung ist auch ein Verfahren zur Herstellung der Folie. Allgemein erfolgt die Herstellung durch ein Extrusions- oder Coextrusionsverfahren, beispielsweise auf einer Extrusionsstraße. Als besonders vorteilhaft hat es sich erwiesen, den bzw. die Hydrolysestabilisator(en) in Form eines vorgetrockneten oder vorkristallisierten Masterbatches vor der Extrusion oder Coextrusion zuzugeben. Der Anteil an Hydrolysestabilisator(en) im Masterbatch beträgt allgemein 5 bis 50 Gew.-%, bevorzugt 6 bis 30 Gew.-%, jeweils bezogen auf das Gesamtgewicht des Masterbatches. Der bzw. die Hydrolysestabilisatoren werden in einem Trägermaterial voll dispergiert. Als Trägermaterial kommen der Thermoplast selbst, z. B. Polyethylenterephthalat oder auch andere Polymere, die mit dem Thermoplasten verträglich sind, in Frage.

Als besonders günstig hat es sich erwiesen, wenn die Korngröße und das Schüttgewicht der Masterbatche gleich oder ähnlich der Korngröße und dem Schüttgewicht des Thermoplasten sind. Dann wird eine homogene Verteilung erreicht, so daß eine Folie mit besonders gleichmäßigen Eigenschaften resultiert.

Die erfindungsgemäße Folien können nach den genannten Verfahren aus einem Polyesterrohstoff, gegebenenfalls weiteren Rohstoffen, mindestens einem Hydrolysestabilisator sowie gegebenenfalls weiteren üblichen Additiven (letztere in üblicher Menge von 0,1 bis 30 Gew.-%, bezogen auf das Gewicht der Folie) als ein- oder als mehrschichtige - gegebenenfalls coextrudierte - Folien mit gleichen oder unterschiedlich ausgebildeten Oberflächen hergestellt werden, wobei eine Oberfläche beispielsweise Partikel enthält und die andere nicht oder alle Schichten Partikel enthalten. Ebenso können eine oder beide Oberflächen der Folie nach bekannten Verfahren mit einer funktionalen Beschichtung versehen werden.

Die Masterbatche, die den oder die Hydrolysestabilisator(en) enthalten, sollten vorkristallisiert oder vorgetrocknet sein. Diese Vortrocknung beinhaltet ein graduelles Erhitzen der Masterbatche unter reduziertem Druck (20 bis 80 mbar, vorzugsweise 30 bis 60 mbar, insbesondere 40 bis 50 mbar) sowie Rühren und gegebenenfalls ein Nachtrocknen bei konstanter, erhöhter Temperatur (ebenfalls unter reduziertem Druck). Die Masterbatche werden vorzugsweise bei Raumtemperatur aus einem Dosierbehälter in der gewünschten Abmischung zusammen mit den Polymeren der Basis- und/oder Deckschichten und ggf. anderen Rohstoffkomponenten chargenweise in einen Vakuumtrockner gefüllt, der im Laufe der Trocken- bzw. Verweilzeit ein Temperaturspektrum von 10 bis 160°C, vorzugsweise 20 bis 150°C, insbesondere 30 bis 130°C durchläuft. Während der etwa 6-stündigen, vorzugsweise 5-stündigen, insbesondere 4-stündigen, Verweilzeit wird die Rohstoffmischung mit 10 bis 70 Upm, vorzugsweise 15 bis 65 Upm, insbesondere 20 bis 60 Upm, gerührt. Das so vorkristallisierte bzw. vorgetrocknete Rohstoffgemisch wird in einem nachgeschalteten ebenfalls evakuierten Behälter bei 90 bis 180 °C, vorzugsweise 100 bis 170°C, insbesondere 110 bis 160 °C, für 2 bis 8 Stunden, vorzugsweise 3 bis 7 Stunden, insbesondere 4 bis 6 Stunden, nachgetrocknet.

Bei dem bevorzugtem Extrusionsverfahren zur Herstellung der Folie wird das aufgeschmolzene Polymermaterial mit den Additiven durch eine Schlitzdüse extrudiert und als weitgehend amorphe Vorfolie auf einer Kühlwalze abgeschreckt. Diese Folie wird anschließend erneut erhitzt und in Längs- und Querrichtung bzw. in Quer- und Längsrichtung bzw. in Längs-, in Quer- und nochmals und Längsrichtung und/oder Querrichtung verstreckt ("orientiert"). Die Strecktemperaturen liegen im allgemeinen 10 bis 60 °C über der Glas-Übergangstemperatur T_{g} der Folie, das Streckverhältnis der Längsstreckung liegt üblicherweise bei 2 bis 6, insbesondere bei 3 bis 4,5, das der Querstreckung bei 2 bis 5, insbesondere bei 3 bis 4,5, und das der gegebenenfalls durchgeführten zweiten Längs- und Querstreckung bei 1,1 bis 5. Die erste Längsstreckung kann auch gleichzeitig mit der Querstreckung (Simultanstreckung) durchgeführt werden. Es folgt die Thermofixierung der Folie, vorzugsweise bei Ofentemperaturen von 180 bis 260 °C, insbesondere von 220 bis 250 °C. Anschließend wird die Folie abgekühlt und gewickelt.

Es war mehr als überraschend, daß durch die Masterbatch-Technologie, kombiniert mit einer geeigneten Vortrocknung und/oder Vorkristallisation, und dem Einsatz von Hydrolysestabilisatoren eine hydrolyse- und hitzestabile Folie mit dem geforderten Eigenschaftsprofil wirtschaftlich und ohne technische Probleme (wie Verklebungen im Trockner) herstellbar ist. Auch der Gelbwert der Folie ist im Vergleich zu einer nicht ausgerüsteten Folie im Rahmen der Meßgenauigkeit nicht negativ verändert.

Durch die Kombination ihrer Eigenschaften eignet sich die erfindungsgemäße Folie für eine Vielzahl verschiedener Anwendungen, beispielsweise für flexible Leiter in der Automobilindustrie, für Flachkabel, für flexible, gedruckte Schaltungen, für Kondensatoren, für Innenraumverkleidungen, für Messebau und Messeartikel, als Displays, für Schilder, für Schutzverglasungen von Maschinen und Fahrzeugen, im Beleuchtungssektor, im Laden- und Regalbau, als Werbeartikel, Kaschiermedium, für Gewächshäuser, Anwendungen im Bausektor und Lichtwerbeprofile, Elektroanwendungen etc.

Die Erfindung wird im Folgenden anhand von Ausführungsbeispielen näher erläutert, ohne darauf beschränkt zu sein. Die Folieneigenschaften wurden wie folgt geprüft:

### Lichttransmission (Transparenz)

Unter der Lichttransmission ist das Verhältnis des insgesamt durchgelassenen Lichtes zur einfallenden Lichtmenge zu verstehen. Die Lichttransmission wurde mit dem Messgerät ®HAZEGARD plus von Byk Gardener, Deutschland, gemäß ASTM D 1003 gemessen.

### Gelbwert

Der Gelbwert (YID) ist die Abweichung von der Farblosigkeit in Richtung "Gelb" und wurde gemäß DIN 6167 gemessen.

### Standardviskosität (SV) und intrinsische Viskosität (IV):

Die Standardviskosität SV wurde - angelehnt an DIN 53726 - als 1 %ige Lösung in Dichloressigsäure (DCE) bei 25°C gemessen. SV (DCE) = (hᵣₑₗ -1) x 1000. Die intrinsische Viskosität (IV) berechnet sich wie folgt aus der Standardviskosität (SV) IV = [η] = 6,907 · 10⁻⁴ SV (DCE ) + 0,063096 [dl/g].

### Oberflächendefekte

Die Oberflächendefekte wurden visuell bestimmt.

### Schrumpf

Der Schrumpf wurde gemäß DIN 40634 nach Hitzeeinwirkung (150°C, 15 Minuten) gemessen.

### Mechanische Eigenschaften

Der E-Modul und die Reißfestigkeit wurden in Längs- und Querrichtung nach ISO 527-1-2 gemessen.

### Klimatest (Feuchte-Langzeittest)

In diesem Test wurde die Folie 1000 h lang bei 85°C und 95% relativer Luftfeuchte im Autoklaven gelagert und danach die Reißfestigkeit in Längs- und Querrichtung gemessen. Die Reißfestigkeit muß mehr als 100 N/mm² betragen, um die Anforderungen der Automobilindustrie zu erfüllen.

### Hochtemperaturfestigkeit

Die Hochtemperaturfestigkeit wurde gemäß IPC TM 650 2.4.9 nach 1.000 h Temperung bei 130°C im Umlufttrockenschrank bestimmt. Nach dieserTemperung muß die Reißfestigkeit gemäß ISO 527-1-2 mehr als 100 N/mm² betragen, um die Anforderungen der Automobilindustrie zu erfüllen.

### Bewitterung (beidseitig), UV-Stabilität

Die UV-Stabilität wurde nach der Testspezifikation ISO 4892 wie folgt geprüft:
- Testgerät:: Atlas Ci 65 Weather Ometer (Fa. Atlas, England)
- Testbedingungen:: ISO 4892, d. h. künstliche Bewitterung
- Bestrahlungszeit:: 1000 Stunden (pro Seite)
- Bestrahlung:: 0,5 W/m², 340 nm
- Temperatur:: 63 °C
- Relative Luftfeuchte:: 50 %
- Xenonlampe:: innerer und äußerer Filter aus Borosilikat
- Bestrahlungszyklen:: 102 Minuten UV-Licht, dann 18 Minuten UV-Licht mit Wasserbesprühung der Proben, dann wieder 102 Minuten UV-Licht usw.

### Brandverhalten

Das Brandverhalten wurde nach DIN 4102 Teil 2, Baustoffklasse B2 und nach DIN 4102 Teil 1, Baustoffklasse B1 sowie nach dem UL-Test 94 ermittelt.

### Bestimmung der Siegelanspringtemperatur (Mindestsiegeltemperatur)

Mit dem Siegelgerät HSG/ET der Firma Brugger wurden heißgesiegelte Proben (Siegelnaht 20 mm x 100 mm) hergestellt, wobei die Folie bei unterschiedlichen Temperaturen mit Hilfe zweier beheizter Siegelbacken bei einem Siegeldruck von 2 bar und einer Siegeldauer von 0,5 s gesiegelt wurde. Aus den gesiegelten Proben wurden Prüfstreifen von 15 mm Breite geschnitten. Die T-Siegelnahtfestigkeit wurde wie bei der Bestimmung der Siegelnahtfestigkeit gemessen. Die Siegelanspringtemperatur ist die Temperatur, bei der eine Siegelnahtfestigkeit von mindestens 0,5 N/15 mm erreicht wird.

### Siegelnahtfestigkeit

Zur Bestimmung der Siegelnahtfestigkeit wurden zwei 15 mm breite Folienstreifen übereinandergelegt und bei 130°C, einer Siegelzeit von 0,5 s und einem Siegeldruck von 2 bar (Gerät: Fa. Brugger, Typ NDS, Deutschland, einseitig beheizte Siegelbacke) gesiegelt. Die Siegelnahtfestigkeit wurde nach der T-Peel-Methode bestimmt.

Alle Folien wurden nach der Testspezifikation ISO 4892 beidseitig je 1000 Stunden pro Seite mit dem Atlas Ci 65 Weather Ometer der Fa. Atlas bewittert und anschließend bezüglich der mechanischen Eigenschaften, der Verfärbung, der Oberflächendefekte und des Glanzes geprüft.

### Beispiele

Bei den nachstehenden Beispielen und Vergleichsbeispielen handelt es sich jeweils um ein- oder mehrschichtige, gedeckt eingefärbte Folien unterschiedlicher Dicke, die auf einer Extrusionsstraße hergestellt wurden. Prozente sind Gewichtsprozente, soweit nicht anders angegeben.

Das Polyethylenterephthalat (Klarrohstoff), aus dem die gedeckt eingefärbte Folie hergestellt wurde, hatte eine Standardviskosität SV (DCE) von 810 (Polyethylenterephthalat RT49 von KoSa, Deutschland) oder eine Standardviskosität SV (DCE) von 770 (Polyethylenterephthalat 4020 von KoSa, Deutschland).

### Die Additive wurden in Form der folgenden Masterbatche zudosiert:

### Masterbatch MB1:

- 10 %: Titandioxid (Anatas-Typ, mittlere Teilchengröße 0,2 µm, von Sachtleben Deutschland) und
- 90 %: Polyethylenterephthalat

### Masterbatch MB2:

- 50 %: Titandioxid (Rutil-Typ, mittlere Teilchengröße 0,2 µm, von DuPont Deutschland) und
- 50 %: Polyethylenterephthalat

### Masterbatch MB3:

- 45 %: Bariumsulfat (®Blanc fixe XR-HX von Sachtleben Chemie GmbH, Deutschland),
- 700 ppm: optischer Aufheller und
- 55 %: Polyethylenterephthalat

### Masterbatch MB4:

- 20 %: Pigmentblau 28 (ein CoAl₂O₄-Spinell; Kobaltblau der Degussa AG, Deutschland) und
- 80 %: Polyethylenterephthalat

### Zur Verbesserung der Hydrolysebeständigkeit wurden mit folgende Masterbatche eingesetzt:

### Masterbatch MB5:

- 6 %: eines phenolischen Hydrolysestabilisators (®Irganox B561, ein Blend aus 80 % Irgafos® 168 und 20 % ®Irganox 1010, Ciba Specialty Chemicals, Basel) und
- 94 %: Polyethylenterephthalat
Schüttgewicht: 750 kg/m³

### Masterbatch MB6:

- 20 %: eines polymeren Polycarbodiimids (®Stabaxol P von Rhein Chemie, Mannheim, Deutschland),
- 80 %: Polyethylenterephthalat
Schüttgewicht: 750 kg/m³

### Zur Verbesserung der UV-Stabilität wurde folgendes Masterbatch eingesetzt:

### Masterbatch MB7:

- 20 %: 2-(4,6-Diphenyl-[1,3,5]triazin-2-yl)-5-hexyloxy-phenol (®Tinuvin 1577 der Ciba Specialty Chemicals, Schweiz) und
- 80 %: Polyethylenterephthalat
Schüttgewicht: 780 kg/m³

### Zur Verbesserung der Schlupfeigenschaften wurde folgendes Masterbatch eingesetzt:

### Masterbatch MB8:

Es enthielt neben PET 10.000 ppm ®Sylobloc 44H (Fa. Grace, Deutschland).

### Um die Folie flammhemmend zu machen, wurde folgendes Masterbatch eingesetzt:

### Masterbatch MB9:

- 25 %: Methanphosphonsäure-bis-(5-ethyl-2-methyl-2-oxo-2λ5-[1,3,2]dioxaphosphinan-5-ylmethylester) (®Amgard P1045 von Albright & Wilson Americas, USA) und
- 75 %: Polyethylenterephthalat

### Beispiel 1

Es wurde eine 75 µm dicke, gedeckt eingefärbte einschichtige Folie hergestellt, die 49 % Polyethylenterephthalat (RT49), 6 % MB1 und 10 % MB6 enthielt. Zusätzlich enthielt die Folie 35 % immanent anfallendes Regenerat.

Die Mischung aus den einzelnen Komponenten wurde bei Raumtemperatur aus separaten Dosierbehältern in einen Vakuumtrockner gefüllt, der vom Einfüllzeitpunkt bis zum Ende der Verweilzeit ein Temperaturspektrum von 25 bis 130 °C durchlief. Während der ca. 4-stündigen Verweilzeit wurde das Rohstoffgemisch mit 61 Umdrehungen pro Minute (Upm) gerührt.

Das vorkristallisierte bzw. vorgetrocknete Rohstoffgemisch wurde dann in einem ebenfalls unter Vakuum stehenden Hopper bei 140 °C 4 Stunden lang nachgetrocknet. Anschließend wurde nach dem beschriebenen Extrusionsverfahren eine 75 µm dicke einschichtige Folie (Monofolie) hergestellt.

### Beispiel 2

Die analog Beispiel 1 hergestellte Monofolie enthielt neben Polyethylenterephthalat RT49 noch 8,0 % MB1,10 % MB6 und 4 % MB8 und 35 % des immanent anfallenden Regenerats. Die Rohstoffmischung wurde wie in Beispiel 1 beschrieben vorgetrocknet.

### Beispiel 3

Analog zu Beispiel 1 wurde eine 75 µm dicke Monofolie hergestellt. Sie enthielt neben PET RT49 noch 10 % MB2, 10 % MB6 und 4 % MB8 und 35 % des immanent anfallenden Regenerats. Die Rohstoffmischung wurde wie im Beispiel 1 beschrieben vorgetrocknet.

### Beispiel 4

Die Folie aus Beispiel 1 wurde in einem Wärmeofen weitestgehend zuglos bei einer Temperatur von 200°C und einer Verweildauer von 60 Sekunden nachbehandelt.

### Beispiel 5

Die Folie aus Beispiel 1 wurde mit Trichloressigsäure chemisch nachbehandelt.

### Beispiel 6

Analog zu Beispiel 1 wurde eine 75 µm dicke Monofolie hergestellt. Im Unterschied zu der Folie gemäß Beispiel 1 enthielt diese Folie 7,5 % MB4 anstelle von 6 % MB1.

### Beispiel 7

Es wurde eine hydrolysestabile ABA-Folie mit folgender Rezeptur hergestellt:
- Basisschicht (72 µm dick):: 57 % Polyethylenterephthalat 4020,
3 % MB2,
5 % MB6 sowie
35 % immanent anfallendes Regenerat
- Deckschichten A (je 1,5 µm):: 83 % Polyethylenterephthalat 4020,
7 % MB8 sowie
10 % MB5

### Vergleichsbeispiel V1

Wie im Beispiel 1 beschrieben wurde eine 75 µm dicke Monofolie hergestellt. Im Unterschied zur Folie aus Beispiel 1 enthielt diese Folie jedoch keinen Hydrolysestabilisator.

### Die Folieneigenschaften sind in der nachfolgenden Tabelle zusammengestellt:

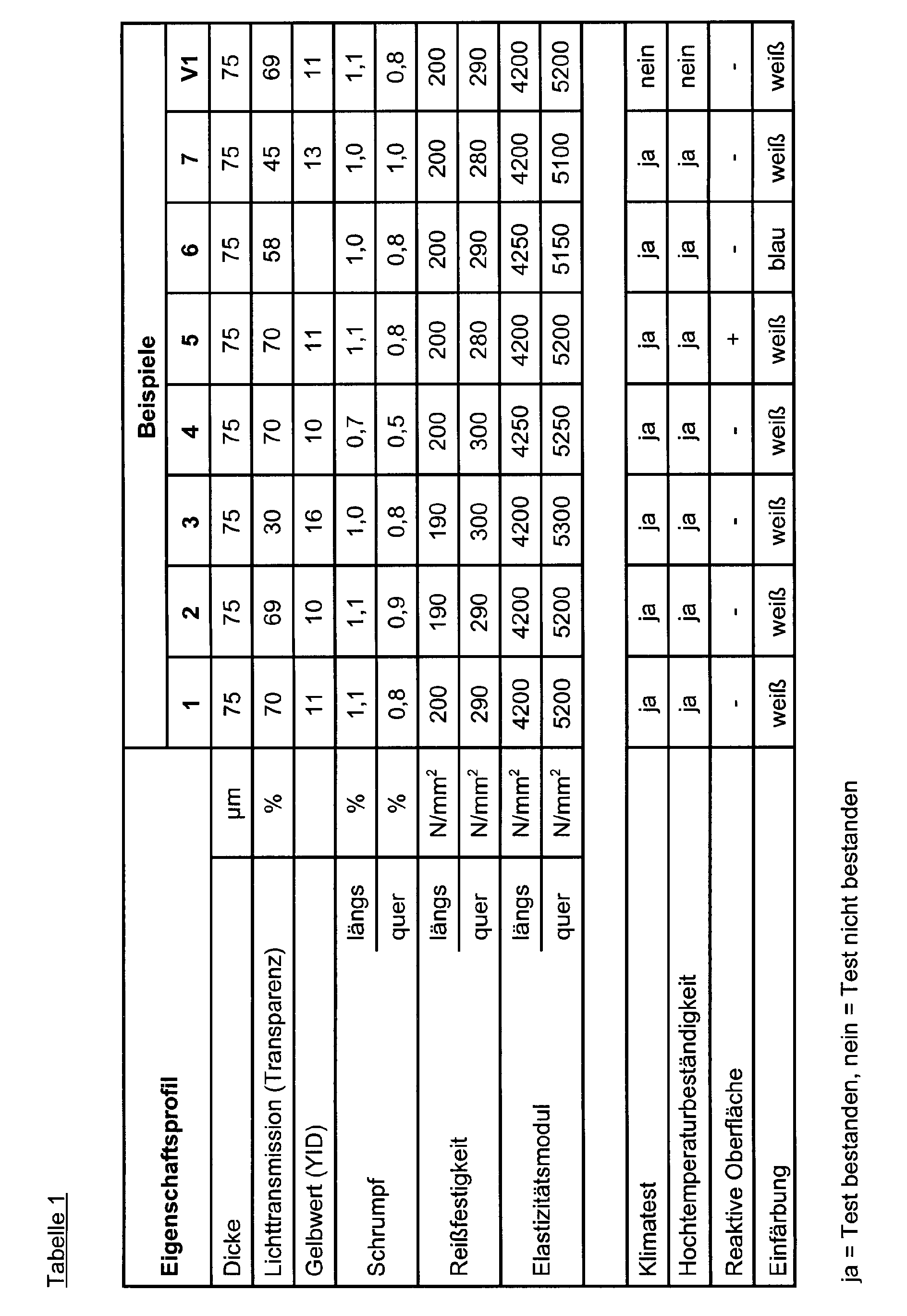

### Beispiel 8

Beispiel 1 wurde wiederholt. In Abänderung zu Beispiel 1 wurde die Folie beidseitig beschichtet. Dazu wurde nach der Längsstreckung die Folie mit Hilfe eines "Reverse gravure-roll coating"-Verfahren mit einer wäßrigen Dispersion beidseitig beschichtet. Die Dispersion enthielt neben Wasser
- 4,20 %: hydrophilischen Polyester (5-Na-sulfoisophthalsäurehaltiges PET/IPA-Polyester, SP41, Ticona, USA),
- 0,15 %: kolloidales Siliciumdioxid (®Nalco 1060, Deutsche Nalco Chemie, Deutschland) als Antiblockmittel sowie
- 0,15 %: Ammoniumcarbonat (Merck, Deutschland) als pH-Puffer.

Das Naßantragsgewicht betrug 2 g/m² pro beschichtete Seite. Nach der Querverstreckung lag die berechnete Dicke der Beschichtung bei 40 nm.

### Beispiel 9

Es wurde eine 75 µm dicke, hydrolysestabile und UV-stabile ABA-Folie hergestellt.
- Basisschicht (72 µm dick):: 40 % PET 4020, 10 % MB1, 10 % MB6, 5 % MB7 sowie 35 % immanent anfallendes Regenerat.
- Deckschichten A (je 1,5 µm dick):: 93 % PET 4020 sowie 7 % MB8.

### Beispiel 10

Es wurde eine hydrolyse- und UV-stabile ABA-Folie hergestellt.
- Basisschicht (72 µm dick):: 27 % PET 4020, 30 % MB3, 5 % MB6, 3 % MB7 (0,6 % UV-Stabilisator) sowie 35 % immanent anfallendes Regenerat.
- Deckschichten A (je 1,5 µm dick):: 78 % PET 4020, 7 % MB8, 10 % MB5 sowie 5 % MB7 (1 % UV-Stabilisator).
Analog zu Beispiel 8 ist die Folie beidseitig beschichtet.

### Beispiel 11

Es wurde mittels Coextrusion eine 12 µm dicke siegelfähige ABC-Folie hergestellt.

Die Basisschicht (10 µm dick) enthielt 50 % PET 4020, 10 % MB1, 10 % MB6 sowie 35 % immanent anfallendes Regenerat.

Für die 1 µm dicke siegelfähige Deckschicht A wurde als Thermoplast ein Copolyester aus 78 mol-% Ethylenterephthalat und 22 mol-% Ethylenisophthalat verwendet (hergestellt durch Umesterung in Gegenwart eines Mangankatalysators, Mn-Konzentration: 100 ppm). Sie enthielt weiterhin 3,0 % des Masterbatches MB8 als Antiblockmittel.

Die 1 µm dicke Deckschicht C enthielt neben 93,0 % PET 4020 7,0 % des Masterbatches MB8.

### Beispiel 12

Wie im Beispiel 11 beschrieben wurde eine 12 µm dicke, hydrolysestabile, gedeckt eingefärbte, coextrudierte, siegelfähige A-B-C-Folie hergestellt. Im Unterschied zu Beispiel 11 wurde die nicht siegelfähige Deckschicht C nach der Längsstreckung durch "Reverse gravure-roll coating" mit einer wäßrigen Dispersion einseitig beschichtet. Die Dispersion hatte die gleiche Zusammensetzung wie im Beispiel 8. Das Naßantragsgewicht betrug 2 g/m². Nach der Querstreckung lag die berechnete Dicke der Beschichtung bei 40 nm.

### Beispiel 13

Analog Beispiel 1 wurde eine 75 µm dicke Monofolie hergestellt. Im Unterschied zur Folie aus Beispiel 1 enthielt die Folie nun zusätzlich 3 % MB9 (0,75 % Flammschutzmittel).

### Beispiel 14

Folie aus Beispiel 13 wurde in einem Wärmeofen weitestgehend zuglos bei einer Temperatur von 200°C und einer Verweildauer von 60 Sekunden nachbehandelt.

### Beispiel 15

Folie aus Beispiel 13 wurde mit Trichloressigsäure chemisch nachbehandelt.

### Beispiel 16

Analog Beispiel 1 wurde eine 75 µm dicke Monofolie hergestellt. Im Unterschied zur Folie aus Beispiel 1 enthielt die Folie anstelle von 6 % MB1 nun 7,5% MB4 (1,5% Pigmentblau 28).

Die Folie wurde einseitig coronabehandelt. Die Intensität war so gewählt, daß die Oberflächenspannung nach der Behandlung mehr als 45 mN/m betrug.

### Vergleichsbeispiel V2

Analog Beispiel 13 wurde eine 75 µm dicke Monofolie hergestellt. Im Unterschied zur Folie aus Beispiel 13 enthielt die Folie keinen Hydrolysestabilisator.

Die Folieneigenschaften sind nachfolgender Tabelle 2 zu entnehmen.

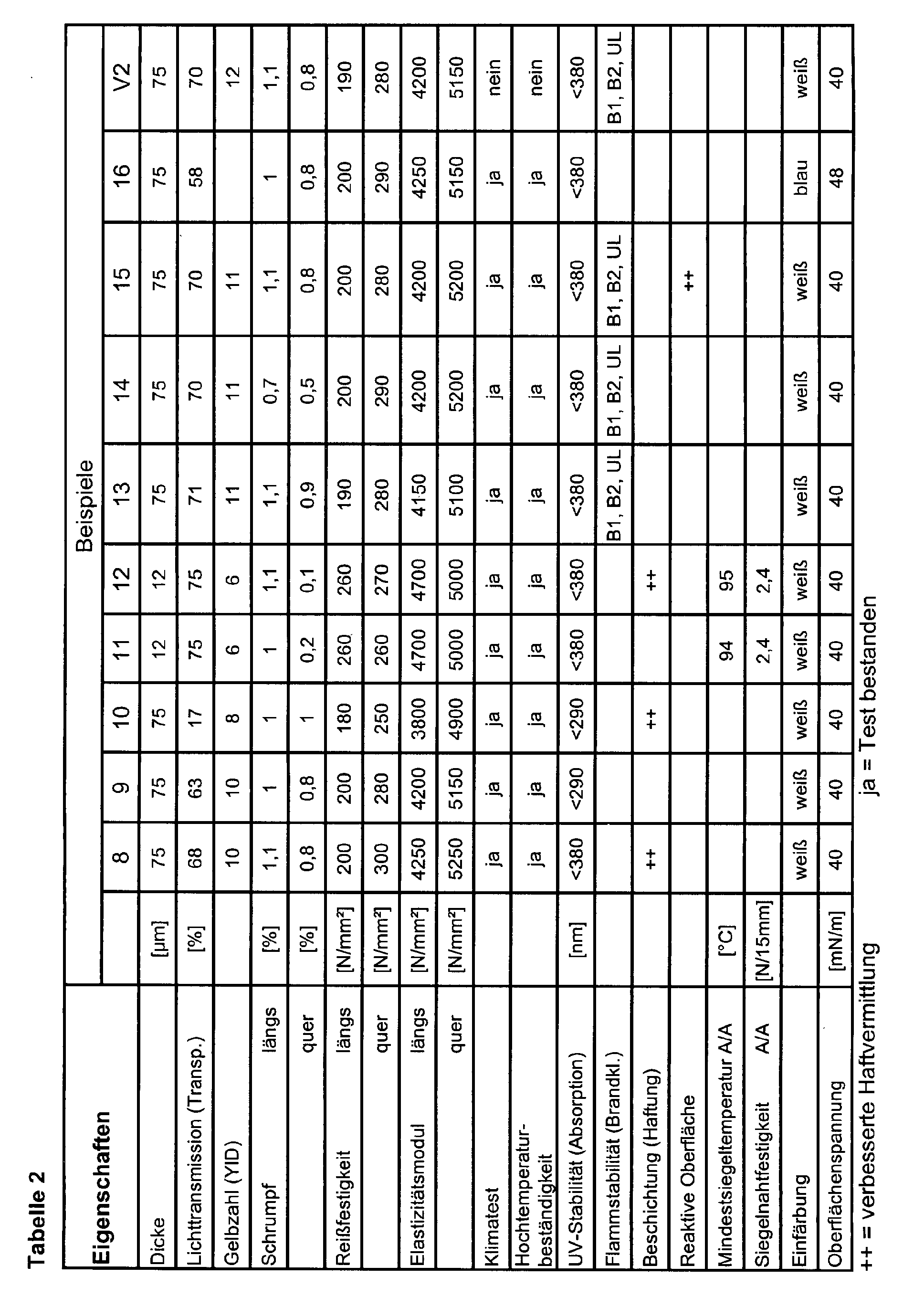

## Patentansprüche

1. Ein- oder mehrschichtige, gedeckt eingefärbte, biaxial orientierte Folie, die mindestens einen kristallisierbaren Thermoplasten als Hauptbestandteil und mindestens ein Pigment enthält, **dadurch gekennzeichnet, daß** sie mindestens ein monomeres, oligomeres oder polymeres Carbodiimid als Hydrolysestabilisator enthält.

2. Folie gemäß Anspruch 1, **dadurch gekennzeichnet, daß** das oligomere oder polymere Carbodiimid ein Molekulargewicht von 2.000 bis 50.000 hat.

3. Folie gemäß Anspruch 1 oder 2, daß der Anteil des monomeren, oligomeren oder polymeren Carbodiimids 0,1 bis 5,0 Gew.-%, bevorzugt 0,2 bis 3,0 Gew.-%, jeweils bezogen auf das Gewicht der einschichtigen Folie bzw. der damit ausgerüsteten Schicht der mehrschichtigen Folie, beträgt.

4. Folie gemäß Anspruch 1, **dadurch gekennzeichnet, daß** sie zusätzlich eine phenolische Verbindung oder ein Oxazolin als weiteren Hydrolysestabilisator enthält.

5. Folie gemäß Anspruch 4, **dadurch gekennzeichnet, daß** die phenolische Verbindung ein sterisch gehindertes Phenol, Thio-bisphenol, Alkylidenbisphenol, Alkylphenol, eine Hydroxybenzylverbindung, ein Acyl-aminophenol und/oder ein Hydroxyphenylpropionat ist.

6. Folie gemäß Anspruch 4 oder 5, **dadurch gekennzeichnet, daß** derAnteil der phenolischen Verbindung 0,1 bis 8,0 Gew.-%, bevorzugt 0,2 bis 5,0 Gew.-%, jeweils bezogen auf das Gewicht der Folie bzw. der damit ausgerüsteten Schicht im Fall der mehrschichtigen Folie, beträgt.

7. Folie gemäß einem oder mehreren der Ansprüche 4 bis 6, **dadurch gekennzeichnet, daß** die phenolische Verbindung kombiniert ist mit mindestens einem organischen Phosphit, insbesondere mit einem Triarylphosphit.

8. Folie gemäß Anspruch 7, **dadurch gekennzeichnet, daß** das Gewichtsverhältnis der phenolischen Verbindung zu dem organischen Phosphit 10 : 90 bis 90 : 10 beträgt.

9. Folie gemäß einem oder mehreren der Ansprüche 1 bis 8, **dadurch gekennzeichnet, daß** sie ein Gemisch aus 0,1 bis 5 Gew.-% an polymeren Carbodiimiden und 0,1 bis 5 Gew.-% eines Blends aus 30 bis 90 Gew.-% eines organischen Phosphits und 70 bis 10 Gew.-% eines Hydroxyphenylpropionats enthält.

10. Folie gemäß einem oder mehreren der Ansprüche 1 bis 9, **dadurch gekennzeichnet, daß** der Anteil aller Hydrolysestabilisatoren zusammen 0,2 bis 13,0 Gew.-%, bevorzugt 0,4 bis 8,0 Gew.-%, jeweils bezogen auf das Gewicht der Folie bzw. der betreffenden Schicht der mehrschichtigen Folie, beträgt.

11. Folie gemäß einem oder mehreren derAnsprüche 1 bis 10, **dadurch gekennzeichnet, daß** sie nach 15 minütigem Erhitzen auf 150 °C einen Schrumpf in Längs- und Querrichtung von jeweils weniger als 2,0 %, bevorzugt weniger als 1,8 %, besonders bevorzugt weniger als 1,6 %, aufweist.

12. Folie gemäß einem oder mehreren der Ansprüche 1 bis 11, **dadurch gekennzeichnet, daß** das Pigment ein anorganisches Weißpigment, ein anorganisches oder organisches Buntpigment, ein anorganisches Schwarzpigment oder eine Mischung davon ist.

13. Folie gemäß Anspruch 12, **dadurch gekennzeichnet, daß** das anorganische Weißpigment Bariumsulfat oder Titandioxid ist.

14. Folie gemäß einem oder mehreren der Ansprüche 1 bis 13, **dadurch gekennzeichnet, daß** der Anteil der Pigmente 0,2 bis 40 Gew.-%, bevorzugt 0,3 bis 25 Gew.-%, beträgt, jeweils bezogen auf das Gewicht des kristallisierbaren Thermoplasten der einschichtigen Folie oder der betreffenden Schicht der mehrschichtigen Folie.

15. Folie gemäß einem oder mehreren der Ansprüche 1 bis 14, **dadurch gekennzeichnet, daß** sie zusätzlich siegelfähig, ein- oder beidseitig beschichtet, chemisch vorbehandelt, corona- und/oder flammbehandelt ist.

16. Folie gemäß Anspruch 15, **dadurch gekennzeichnet, daß** sie oder mindestens eine ihrer Schichten einen UV-Stabilisator enthält.

17. Folie gemäß Anspruch 16, **dadurch gekennzeichnet, daß** der UV-Stabilisator ein 2-Hydroxy-benzophenon, ein 2-Hydroxy-benzotriazol, eine nickelorganische Verbindung, ein Salicylsäureester, ein Zimsäureester-Derivat, Resorcin-monobenzoat, ein Oxalsäureanilid, ein Hydroxybenzoesäureester, ein Benzoxazinon, ein sterisch gehindertes Amin oder ein Triazin ist.

18. Folie gemäß Anspruch 16 oder 17, **dadurch gekennzeichnet, daß** der UV-Stabilisator 2-(4,6-Diphenyl-[1,3,5]triazin-2-yl)-5-hexyloxy-phenol, 2,2'-Methylen-bis-[6-benzotriazol-2-yl-4-(1,1,2,2-tetramethyl-propyl)-phenol] und/oder 2,2'-(1,4-Phenylen)-bis-[[1,3]benzoxazin-4-on] ist.

19. Folie gemäß Anspruch 16, **dadurch gekennzeichnet, daß** der Anteil an UV-Stabilisator(en) 0,1 bis 5,0 Gew.-%, bevorzugt 0,5 bis 3,0 Gew.-%, beträgt, jeweils bezogen auf das Gesamtgewicht der einschichtigen Folie oder der betreffenden Schicht der mehrschichtigen Folie.

20. Folie gemäß einem oder mehreren der Ansprüche 1 bis 19, **dadurch gekennzeichnet, daß** sie ein Flammschutzmittel enthält, bevorzugt eine Bromverbindung, ein Chlorparaffin oder eine andere Chlorverbindung, Antimontrioxid, Aluminiumhydroxid oder eine monomere oder polymere organische Phosphorverbindung.

21. Folie gemäß Anspruch 20, **dadurch gekennzeichnet, daß** der Anteil an Flammschutzmittel 0,5 bis 30,0 Gew.-%, bevorzugt 1,0 bis 20,0 Gew.-%, beträgt, jeweils bezogen auf das Gesamtgewicht der einschichtigen Folie oder der betreffenden Schicht der mehrschichtigen Folie.

22. Verfahren zur Herstellung der Folie gemäß einem oder mehreren der Ansprüche 1 bis 21, **dadurch gekennzeichnet, daß** ein Gemisch, das mindestens einen kristallisierbaren Thermoplast als Hauptbestandteil und mindestens einen Hydrolysestabilisator umfaßt, in einem Extruder aufgeschmolzen und durch Extrusion oder Coextrusion zu einer ein- oder mehrschichtigen Folie geformt wird, wobei der mindestens eine Hydrolysestabilisator in Form eines vorkristallisierten oder vorgetrockneten Masterbatches vor der Extrusion oder Coextrusion zugegeben wird.

23. Verfahren gemäß Anspruch 22, **dadurch gekennzeichnet, daß** der Anteil des mindestens einen Hydrolysestabilisators 5 bis 50 Gew.-%, bevorzugt 6 bis 30 Gew.-%, jeweils bezogen auf das Gesamtgewicht des Masterbatches, beträgt.

24. Verfahren gemäß Anspruch 22 oder 23, **dadurch gekennzeichnet, daß** die bei der Extrusion gebildete weitgehend amorphe Vorfolie auf einer Kühlwalze abgeschreckt, anschließend erneut erhitzt, in Längs- und/oder Querrichtung verstreckt und schließlich thermofixiert wird.

25. Verwendung der Folie gemäß einem oder mehreren der Ansprüche 1 bis 21 für flexible Leiter in der Automobilindustrie, für Flachkabel, für flexible, gedruckte Schaltungen, für Kondensatoren, für Innenraumverkleidungen, für den Messebau und Messeartikel, für Displays, Schilder oder Schutzverglasungen von Maschinen und Fahrzeugen, im Beleuchtungssektor, im Laden- und Regalbau, als Werbeartikel, Kaschiermedium, für Gewächshäuser, im Bausektor, für Lichtwerbeprofile oder im Elektrobereich.
